# EUROPEAN PATENT APPLICATION

(11) **EP 3 620 237 A1**
(43) Date of publication of application: **11.03.2020**
(21) Application number: 18193419.1
(22) Date of filing: 10.09.2018
(51) Int. Cl.: B06B 1/06, G06F 3/01, H01L 41/09

(54) **HAPTIC FEEDBACK ACTUATOR, TOUCH SCREEN COMPRISING THE SAME AND METHOD FOR PRODUCING A TOUCH SCREEN**

(71) Applicant: Robert Bosch GmbH, 70442 Stuttgart (DE)
(72) Inventor: Beruscha, Frank, 71665 Kleinglattbach (DE); Denes, Istvan, 71277 Rutesheim (DE); So, Yong Heng, 564596 Singapur (SG)

(57) **Abstract**

A haptic feedback actuator comprising a substrate and an electroactive layer structure disposed on the substrate, wherein the electroactive layer structure comprises an electroactive layer between a bottom electrode layer and a top electrode layer, and wherein the electroactive layer structure further comprises a wave-like in a longitudinal direction. A touch screen comprising the haptic feedback actuator. A method of producing the touch screen, the method comprises providing the substrate, and disposing the electroactive layer structure on the substrate.

## Description

### TECHNICAL FIELD

The present disclosure relates to a haptic feedback actuator, a touch screen including a haptic feedback actuator, and a method for producing a touch screen.

### BACKGROUND

Touch screens with haptic feedback were recently introduced to enhance the user experience when interacting with content on a screen. In most cases, haptic feedback is generated with electromechanical or electromagnetic actuators that are mounted under the touch screen and actuate the whole screen. Such actuators increase the required size of the screen due to the size of the required electromechanical components. Further, the haptic feedback is limited to a vibration of the whole screen.

Therefore, there is a need to provide for an improved haptic feedback actuator.

### SUMMARY

It is therefore, object of the invention to provide an improved haptic feedback actuator and an improved touch screen including a haptic feedback actuator.

Various embodiments may provide a haptic feedback actuator which may include a substrate and an electroactive layer structure. The electroactive layer structure may be disposed on the substrate. The electroactive layer structure may include an electroactive layer between a bottom electrode layer and a top electrode layer. The electroactive layer structure may further include a wave-like profile in a longitudinal direction.

Various embodiments may provide a touch screen including the haptic feedback actuator.

Various embodiments may provide a method of producing the touch screen, the method may include providing the substrate and providing (e.g. disposing, e.g. forming) the electroactive layer structure on the substrate.

### BRIEF DESCRIPTION OF THE DRAWINGS

In the following description, various embodiments of the present disclosure are described with reference to the following drawings, in which:
- FIG. 1A shows a schematic illustration of a planar electroactive actuator 100, without application of electrical stimulus;
- FIG. 1B shows the same planar electroactive actuator 100 of FIG. 1 under application of an electrical stimulus;
- FIG. 2A shows a schematic illustration of a haptic feedback device 200, according to various embodiments;
- FIG. 2B shows the same haptic feedback device 200 of FIG. 2A under application of an electrical stimulus;
- FIG. 3 shows a schematic illustration of a haptic feedback device 300 comprising an electroactive layer structure 310 disposed on a wave-like anti-reflective layer structure 380, according to various embodiments.

### DETAILED DESCRIPTION

In the description which follows, the drawing figures are not necessarily to scale and certain features may be shown in generalized or schematic form in the interest of clarity and conciseness or for informational purposes.

The following detailed description describes specific details and embodiments in which the invention may be practiced. These embodiments are described in sufficient detail to enable those skilled in the art to practice the invention. Other embodiments may be utilized and changes may be made without departing from the scope of the invention. The various embodiments are not necessarily mutually exclusive, as some embodiments can be combined with one or more other embodiments to form new embodiments.

Features that are described in the context of an embodiment may correspondingly be applicable to the same or similar features in the other embodiments. Features that are described in the context of an embodiment may correspondingly be applicable to the other embodiments, even if not explicitly described in these other embodiments. Furthermore, additions and/or combinations and/or alternatives as described for a feature in the context of an embodiment may correspondingly be applicable to the same or similar feature in the other embodiments.

The invention illustratively described herein may suitably be practiced in the absence of any element or elements, limitation or limitations, not specifically disclosed herein. Thus, for example, the terms "comprising", "including," containing", etc. shall be read expansively and without limitation. The word "comprise" or variations such as "comprises" or "comprising" will accordingly be understood to imply the inclusion of a stated integer or groups of integers but not the exclusion of any other integer or group of integers. Additionally, the terms and expressions employed herein have been used as terms of description and not of limitation, and there is no intention in the use of such terms and expressions of excluding any equivalents of the features shown and described or portions thereof, but it is recognized that various modifications are possible within the scope of the invention claimed. Thus, it should be understood that although the present invention has been specifically disclosed by exemplary embodiments and optional features, modification and variation of the inventions embodied herein disclosed may be resorted to by those skilled in the art, and that such modifications and variations are considered to be within the scope of this invention.

The reference signs included in parenthesis in the claims are for ease of understanding of the invention and have no limiting effect on the scope of the claims.

A haptic feedback actuator may include an electroactive layer structure, including an electroactive polymer between a bottom electrode layer and a top electrode layer. The electroactive layer structure may be deposited on a substrate. The bottom electrode layer may be arranged between the electroactive layer and the substrate, while the top electrode layer may be arranged on a surface of the electroactive layer which is furthest from the substrate.

Within the scope of the present disclosure and in accordance with various embodiments, the expression "electroactive layer" may mean a layer which may undergo a shape change in response to an applied electrical field. The electroactive layer may include an electroactive material, e.g. an electroactive polymer. Within the context of the present disclosure and in accordance to various embodiments, an electroactive material, e.g., an electroactive polymer (EAP), is a material (a polymer in case of EAP) that undergoes shape change in response to an applied electrical field. An exemplary class of electroactive materials is the ferroelectroactive polymers (FerroEAP).

Examples of ferroelectric FerroEAP are: poly (vinylidenefluoride - trifluoroethylene - chlorotrifluoroethylene) (abbreviated as P(VDF-TrFE-CTFE), poly (vinylidenefluoride - trifluoroethylene - chlorofluoroethylene) (abbreviated as P(VDF-TrFE-CFE), Poly(vinylidene fluoride-co-hexafluoropropylene) (P(VDF-TrFE-HFP)).

Examples of transparent electrode materials are: silver nanowire (abbreviated as AgNW), poly (3,4-ethylenedioxythiophene) polystyrene sulfonate (abbreviated as PEDOT:PSS), Indium Tin Oxide (abbreviated as ITO)

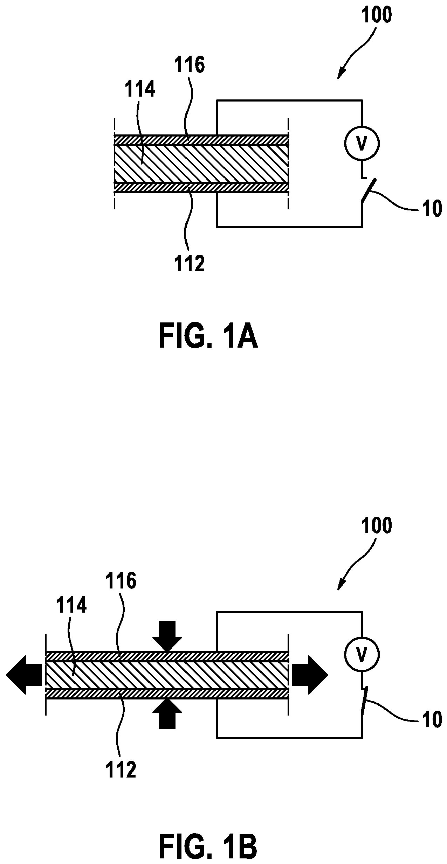

A planar haptic feedback actuator 100 will be explained in connection with FIG. 1A and FIG. 1B, which show a haptic feedback actuator with planar layers. The haptic feedback actuator 100 is shown without electrical stimulus in FIG. 1A, wherein switch 10 is open thus providing an open circuit, and with electrical stimulus in FIG. 1B, wherein switch 10 is closed thus providing a closed circuit. The use of an electroactive material, e.g. electroactive polymers (EAP), for haptic actuation is advantageous. For example, disposing the electroactive material as a transparent layer on top of a touch screen may allow for seamless integration of haptic feedback on large and curved screens. The electroactive layer 114 may be disposed between the top electrode layer 116 and the bottom electrode layer 112, both electrodes 112 and 116 may be transparent. An electric stimulus to the electroactive layer 114 may cause its change of shape, for example when voltage is applied at the electrodes 112 and 116, the electroactive layer 114 deforms due to the application of the corresponding electric field, as is illustrated by arrows in FIG. 1B, for example in length and thickness. This deformation may be felt as a haptic feedback. Several layers of electroactive layer with electrodes in between may be used to enhance the haptic feedback strength.

For flat haptic feedback actuators, the deformation in length may be considerably larger than the change in thickness.

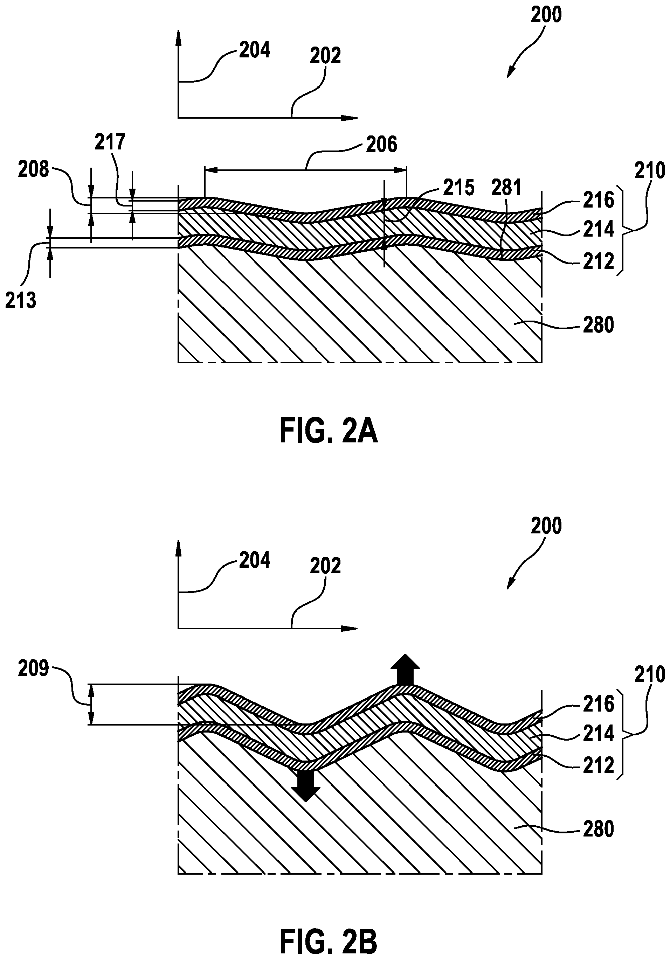

FIG. 2A shows a haptic feedback actuator 200 according to various embodiments. The haptic feedback actuator 200 may include an electroactive layer structure 210 including an electroactive layer 214 between a bottom electrode layer 212 and a top electrode layer 216. The electroactive layer structure 210 may include a wave-like profile in a longitudinal direction 202. The haptic feedback actuator 200 may include a substrate 280. The electroactive layer structure 210 may be disposed on the substrate 280. FIG. 2A shows a wave-like profile with a wavelength 206 and a wave height 208. The bottom electrode layer 212 has a layer thickness 213, the electroactive layer has a layer thickness 215, and the top electrode layer has a layer thickness 217.

Characteristics of the layers and the wave-like profile as disclosed herein, are described for the electroactive layer structure without electrical stimulus, unless explicitly mentioned otherwise. For example, definitions and explanation in connection with the wave-like profile of the electroactive layer structure or substrate, such as wavelength in a longitudinal direction, or wave height, if not explicitly mentioned that it is under electrical stimulus, refer to the case without electrical stimulus.

Within the scope of the present disclosure and in accordance with various embodiments, the expression "a longitudinal direction" may mean in at least one longitudinal direction, for example in any longitudinal direction. The term "longitudinal" may mean along a length, or a width, or a parallel thereof, of a layer or layer stack. For example, a layer or layer stack may have a width, a length, and a height, wherein the height is the smallest dimension of all three. The width, length, and height may be essentially orthogonal to each other. In the figures, one longitudinal direction is represented by direction 202 or 302, and the height is represented by 204 or 304, respectively.

Within the scope of the present disclosure and in accordance with various embodiments, the term "equal" as used in relation to layer properties, for example while comparing thicknesses or profiles, may mean substantially equal and may include small deviations such as manufacturing tolerances.

Within the scope of the present disclosure and in accordance with various embodiments, the term "surface" as used in the present disclosure in connection with a layer, may refer to one of both major opposing surfaces of a layer. The plural form "surfaces" may refer to both of the major opposing surfaces of a layer.

According to various embodiments, the wave-like profile may include a wavelength of more than or equal to 50 micrometers and less than or equal to 100 micrometers. The wavelength may be measured using, for example, surface-topography measurement such as surface profilometer with the use of stylus probe to detect, or physically measure the surface. Physically moving a probe along the surface in conjunction with a feedback loop to maintain a constant force allows for the acquisition of surface height and roughness information along the scan line. The distance between the two peaks measured along the scan line on surface of electroactive layer 210 will be the wavelength. Alternatively, atomic force microscopy (AFM) can be used to measure 3D topography scan for the surface of electroactive layer 210. The wavelength can be obtained by measuring the separation between the two peaks on the 3D scan.

According to various embodiments, the wave-like profile may include a wave height of less than or equal to 50 micrometers. The wave height may be measure surface-topography measurement such as surface profilometer, for example together with the measurement of the wavelength. Alternatively, the wave height may be measured using, for example, AFM or thin film thickness measurement based on spectroscopic reflectance with the use of fiber optics retro-reflecting probe. The differences between thickness measured at the crest and trough of the electroactive layer structure 210 will be the wave height.

For wavelength and wave height measurements, surface-topography measurement such as surface profilometer may be preferred.

The wave-like profile increases the haptic feedback strength.

According to various embodiments, at least one of: the electroactive layer, the bottom electrode layer, the top electrode layer, may include the wave-like profile in the longitudinal direction. For example, as illustrated in FIG. 2A, each of the electroactive layer 214, the bottom electrode layer 212, and the top electrode layer 216, include the wave-like profile in the longitudinal direction 202. The overall electroactive layer structure 210 may include a thickness of less than or equal to 10 micrometers.

According to various embodiments, a surface of the top electrode layer which is distal (e.g., facing away) from the electroactive layer and a surface of the top electrode layer which is proximal to (e.g., facing) the electroactive layer may have geometric shapes complementary to each other. Such complementarity is illustrated, e.g. in FIG. 2A, wherein both surfaces of top electrode layer 216 have a same wave-like profile, and are therefore complementary to each other in shape, for example, where the top surface (distal from the electroactive layer 214) of the top electrode layer 216 has a convexity, the bottom surface (proximal to the electroactive layer 214) of the top electrode layer 216 has a matching concavity.

According to various embodiments, a surface of the electroactive layer 214 which is proximal to the bottom electrode layer 212 and a surface of the electroactive layer 214 is proximal to the top electrode layer 216 have shapes complementary to each other. Such complementarity is illustrated, e.g. in FIG. 2A, wherein both surfaces of electroactive layer 214 have a same wave-like profile, and are therefore complementary to each other in shape, for example, wherein the top surface (distal from the bottom electrode layer 212) of the electroactive layer 214 has a convexity, the bottom surface (proximal to the bottom electrode layer 212) of the electroactive layer 214 has a matching concavity.

In some embodiments, a surface of the bottom electrode layer which is distal (e.g., facing away) from the electroactive layer and a surface of the bottom electrode layer which is proximal to (e.g., facing) the electroactive layer may have geometric shapes complementary to each other. Such complementarity is illustrated, e.g. in FIG. 2A, wherein both surfaces of bottom electrode layer 212 have a same wave-like profile, and are therefore complementary to each other in shape, for example, wherein the bottom surface (distal from the electroactive layer 214) of the bottom electrode layer 212 has a concavity, the top surface (proximal to the electroactive layer 214) of the bottom electrode layer 212 has a matching convexity.

According to various embodiments, the thickness variation of the electroactive layer may be smaller than the wave height of the wave-like profile. For that purpose, the thickness variation and the wave height may be compared in a same direction, for example in the longitudinal direction. According to various embodiments, the thickness of the electroactive layer may be constant in the longitudinal direction. For example, as illustrated in FIG. 2A, electroactive layer 214 has a thickness 215, which is shown as constant and therefore with variation smaller (essentially zero) as compared to the wave height 208.

According to various embodiments, the thickness variation of the top electrode layer may be smaller than the wave height of the wave-like profile of the top electrode layer. For that purpose, the thickness variation and the wave height may be compared in a same direction, for example in the longitudinal direction. According to various embodiments, the thickness of the top electrode layer may be constant in the longitudinal direction. For example, as illustrated in FIG. 2A, the top electrode layer 216 has a thickness 217, which is shown as constant.

FIG. 2B shows the same haptic feedback device 200 of FIG. 2A, however now under application of an electrical stimulus. An electric stimulus to the electroactive layer 200 may cause its change of shape, for example when voltage is applied at the electrodes 212 and 216, an electric field is generated that deforms the electroactive layer 214, as is illustrated by the arrows in FIG. 2B, for example in length and thickness. Due to the wave-like profile, the wave-height 209 under electrical stimulus is higher than the wave-height 208 without electrical stimulus. As shown in FIG. 2B, the change in length can be transferred into a change in height when the electroactive layer structure is arranged in a wave-like configuration. This deformation may be felt as a haptic feedback.

An electric stimulus to the electroactive layer 114 may cause its change of shape, for example when voltage is applied at the electrodes 112 and 116, an electric field is generated that deforms the electroactive layer 114, as is illustrated by arrows in FIG. 1B, for example in length and thickness. This deformation may be felt as a haptic feedback.

According to various embodiments, several layers of electroactive layer with electrodes in between may be used to enhance the haptic feedback strength.

In some embodiments, the bottom electrode layer may serve as a template for the wave-like profile. The bottom electrode layer may have a thickness variation corresponding to the wave-like profile in the longitudinal direction. For example, the substrate may include an essentially flat top surface (proximal to the electroactive layer), for example, including an anti-reflection layer.

In some embodiments, the bottom surface (distal from the electroactive layer) of the bottom electrode layer may be essentially flat, while the top surface (proximal to the electroactive layer) of the bottom electrode layer may include the wave-like profile in the longitudinal direction.

In some embodiments, the substrate may include a top surface profile including the wave-like profile, and the electroactive layer structure may acquire the wave-like profile in the longitudinal direction, e.g. once the electroactive layer structure is deposited over the substrate, wherein the substrate serves as a template. Accordingly, in some embodiments, the top surface profile of the substrate in the longitudinal direction may be equal to the wave-like profile in the longitudinal direction.

In some embodiments, the top surface profile of the substrate in the longitudinal direction may be equal to the wave-like profile in the longitudinal direction. For example, as illustrated in FIG. 2A, the substrate 280 has a top surface profile 281 which is wave-like and the electroactive layer structure, which is disposed on the substrate, has a wave-like profile, which follows the wave-like profile from the substrate, for example all the way to the top surface 218 (which is distal from the electroactive layer) of the top electrode layer 216.

In some embodiments, the thickness of the bottom electrode layer may be constant in the longitudinal direction. For example, as illustrated in FIG. 2A, the bottom electrode layer 212 has a thickness 213, which is shown as constant.

In some embodiments, the substrate may be an anti-glare layer.

In some embodiments, the deposition of the electroactive layer including a wave-like profile may be compatible with already existing wave-like layers in a touch screen system, e.g. anti-glare layer.

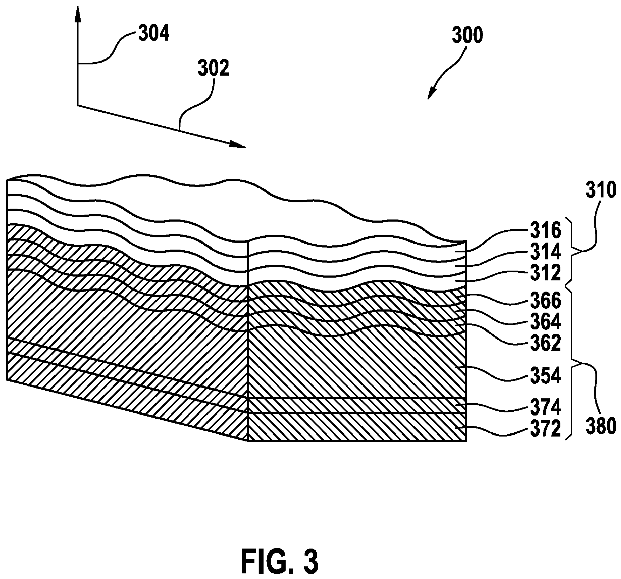

FIG. 3 shows a schematic illustration of a haptic feedback device 300 comprising an electroactive layer structure 310 disposed on a wave-like anti-reflective layer structure 380, according to various embodiments. The haptic feedback device 300 includes a substrate 380 with a top surface including a wave-like profile. The electroactive layer structure 310 may include an electroactive layer 314 between a bottom electrode layer 312 and a top electrode layer 316. The electroactive layer structure is disposed on the substrate 380, thereby conforming to the substrate's profile.

According to some embodiments, and as an exemplified in FIG. 3, the substrate may be an anti-glare layer. For example, the substrate may include a base layer 354, the base layer 354 may include a top surface profile which may give the anti-glare effect. An example of a base layer is a transparent polymer, for example polyethylene terephthalate. The substrate 380 may also be a combined anti-glare and anti-reflective layer, for example the substrate may further include a hard coat layer 362 disposed on the base layer 354, an anti-reflective layer 364 disposed on the hard coat layer 362, and may further include an anti-static layer 366 disposed on the hard coat layer 362. As shown in FIG. 3, the top surface profile of the substrate 380 in the longitudinal direction 302 may be equal to the wave-like profile in the longitudinal direction 302 of the electroactive layer structure.

According to various embodiments, each of the layers of the haptic feedback actuator may be transparent, for example all layers may be transparent.

According to various embodiments, the haptic feedback actuator may include a cover layer, which may be disposed on the electroactive layer structure. The cover layer may be wave-like shaped, meaning, including the wave-like profile, on both surfaces, or may have a flat shape on top and the wave-like profile at the bottom side to fit the underneath electroactive layer structure.

The present disclosure also concerns a touch screen comprising the haptic feedback actuator according to various embodiments. For example, the touch screen may be part of a display, and the haptic feedback actuator may be disposed on the display.

The present disclosure also concerns a method of producing the touch screen according to various embodiments, the method may include: providing the substrate; and disposing the electroactive layer structure on the substrate.

## Claims

1. A haptic feedback actuator (200, 300) comprising a substrate (280, 380) and an electroactive layer structure (210, 310) disposed on the substrate (280, 380), wherein the electroactive layer structure (210, 310) comprises an electroactive layer (214, 314) between a bottom electrode layer (212, 312) and a top electrode layer (216, 316), and wherein the electroactive layer structure (210, 310) further comprises a wave-like profile in a longitudinal direction (202, 302).

2. The haptic feedback actuator (200, 300) of claim 1, wherein the wave-like profile comprises a wavelength (206) of less than 100 micrometers.

3. The haptic feedback actuator (200, 300) of claim 2, wherein the wave-like profile comprises a wave height (208) of less than or equal to 50 micrometers.

4. The haptic feedback actuator (200, 300) of any of the previous claims, wherein at least one of: the electroactive layer (214, 314), the bottom electrode layer (212, 312), the top electrode layer (216, 316), comprises the wave-like profile in the longitudinal direction (202, 302).

5. The haptic feedback actuator (200, 300) of any of the previous claims, wherein the electroactive layer (214, 314), the bottom electrode layer (212, 312), and the top electrode layer (216, 316), each comprises the wave-like profile in the longitudinal direction (202, 302).

6. The haptic feedback actuator (200, 300) of any of the previous claims, wherein a surface of the top electrode layer (216, 316) which is distal from the electroactive layer (214, 314) and a surface of the top electrode layer (216, 316) which is proximal to the electroactive layer (214, 314) have shapes complementary to each other.

7. The haptic feedback actuator (200, 300) of any of the previous claims, wherein a surface of the electroactive layer (214, 314) which is proximal to the bottom electrode layer (212, 312) and a surface of the electroactive layer (214, 314) which is proximal to the top electrode layer (216, 316) have shapes complementary to each other.

8. The haptic feedback actuator (200, 300) of any of the previous claims, wherein a thickness variation of the electroactive layer (214, 314) is smaller than the wave height (208) of the wave-like profile in the longitudinal direction.

9. The haptic feedback actuator (200, 300) of any of the previous claims, wherein a thickness (215) of the electroactive layer (214, 314) is constant in the longitudinal direction (202, 302).

10. The haptic feedback actuator (200, 300) of any of the previous claims, wherein a thickness (217) of the top electrode layer (216, 316) is constant in the longitudinal direction (202, 302).

11. The haptic feedback actuator (200, 300) of any of the previous claims, wherein a thickness (213) of the bottom electrode layer (212, 312) is constant in the longitudinal direction (202, 302).

12. The haptic feedback actuator (200, 300) of any of the previous claims, wherein a surface of the bottom electrode layer (212, 312) which is distal from the electroactive layer (214, 314) and a surface of the bottom electrode layer (212, 312) which is proximal to the electroactive layer (214, 314) have shapes complementary to each other.

13. The haptic feedback actuator (200, 300) of any of the previous claims, wherein a top surface profile of the substrate (280, 380) in the longitudinal direction (202, 302) is equal to the wave-like profile in the longitudinal direction (202, 302).

14. The haptic feedback actuator (200, 300) of any of the previous claims 1 to 10, wherein the bottom electrode layer has a thickness variation corresponding to the wave-like profile in the longitudinal direction.

15. The haptic feedback actuator (200, 300) of any of the previous claims, wherein the substrate (280, 380) includes or is an anti-glare layer.

16. A touch screen comprising the haptic feedback actuator (200, 300) according to any of the previous claims.

17. A method of producing the touch screen of claim 16, the method comprising:
- providing the substrate (280, 380);
- providing the electroactive layer structure (210, 310) having the wave-like profile in the longitudinal direction (202, 302) on the substrate (280, 380).
